# EUROPEAN PATENT SPECIFICATION

(11) **EP 4 649 525 B1**
(45) Date of publication and mention of the grant of the patent: **25.11.2026**
(21) Application number: 24700506.9
(22) Date of filing: 10.01.2024
(51) Int. Cl.: H10P 72/76

(54) **SYSTEM FOR TREATING AN INDIVIDUAL WAFER MANUFACTURED FROM SEMICONDUCTOR MATERIAL, AND METHODS**
SYSTEM ZUR BEHANDLUNG EINES AUS HALBLEITERMATERIAL HERGESTELLTEN EINZELWAFERS UND VERFAHREN
SYSTÈME DE TRAITEMENT D'UNE TRANCHE INDIVIDUELLE FABRIQUÉE À PARTIR D'UN MATÉRIAU SEMI-CONDUCTEUR ET PROCÉDÉS

(30) Priority: 11.01.2023 NL 2033951
(43) Date of publication of application: 19.11.2025
(73) Proprietor: Levitech B.V., 1362 AE Almere (NL)
(72) Inventor: VAN VELZEN, Wilhelmus Gerardus, 1362 AE Almere (NL); VAN DER WAL, Martijn Gerben, 1362 AE Almere (NL); VAN DER LINDE, Simon Cornelis, 1362 AE Almere (NL); KUZNETSOV, Vladimir Ivanovich, 1362 AE Almere (NL); BEIJERSBERGEN, Jacobus Hubertus Maria, 1362 AE Almere (NL); OTERDOOM, Jeppe Elzo, 1362 AE Almere (NL)
(74) Representative: V.O.
(86) International application number: PCT/NL2024/050008
(87) International publication number: WO 2024/151160

(56) References cited:
- EP-A1- 1 111 658
- US-A1- 2003 047 199
- US-A1- 2012 231 628
- US-A1- 2019 062 904

## Description

### FIELD

The invention relates to: a system for treating an individual wafer manufactured from semiconductor material; methods of operating the system; a method of treating the wafer using the system; a controller for the system; and a computer program product for the controller.

### BACKGROUND

Systems for treating an individual wafer manufactured from semiconductor material are known as such. Examples of such a system are disclosed in EP1111658 A1, US2003047199 A1, and US2019062904 A1. In use, heat may be transferred from the movable bodies of the system to the wafer, in particular by conduction, to thereby treat the wafer, in particular by so-called rapid thermal annealing (RTA).

The treatment area where the wafer is heated is typically arranged in an environmentally controlled process chamber, to control supply and removal of process gasses around the wafer and to inhibit contamination e.g. by particles and foreign metals that could otherwise lead to failures. As a barrier against ingress of contaminants, sealing means may be employed to some extent, typically made from rubber or polymer materials. However, those materials may be incompatible with high temperatures occurring during treatment, in particular near movable bodies that are used for heating the wafer. As an alternative or additional measure, it is therefore preferred that the process chamber is maintained at an overpressure compared to its surroundings. However, a disadvantage of such an overpressure is that relatively expensive process gas fed into the process chamber may thereby leak out of the process chamber, prompting replacement thereof with associated costs. To help save costs, it is thus preferred to set the level of overpressure only just high enough to prevent entry of contaminants. The level of the overpressure is typically controlled via one or more controllable gas supplies feeding into the process chamber, for example based on pressure measurements from a pressure sensor in the process chamber. Although many advantages are obtained in this way, further improvements are still desired, in particular to allow faster handling of wafers before and/or after treatment.

### SUMMARY

An object of the present invention is to enable faster wafer processing for individual wafer treatment, in particular annealing, substantially without increasing contamination or costs. An object is to make processes for individual wafer treatment more efficient. An object is to provide a relatively compact, economical and versatile wafer treatment system, or at least an alternative wafer treatment system.

Thereto, an aspect provides a system for treating an individual wafer manufactured from semiconductor material. The system comprises a process chamber bound by a process chamber wall defining an interior volume of the process chamber. The process chamber is provided with a first and a second body arranged for movably extending through the process chamber wall to be movable away from each other from a closed position to an opened position, and towards each other from the opened position to the closed position. In the closed position, a wafer positioned in a treatment area between the first and second bodies can be treated via the first and second bodies, in particular by heating for rapid thermal annealing. In the opened position, the wafer can be moved into and out from the treatment area. In the opened position the first and second bodies occupy less of the interior volume of the process chamber compared to the closed position.

The process chamber is further provided with a third body arranged for movably extending through the process chamber wall to be movable between an inward position and an outward position. In the outward position, the third body occupies less of the interior volume of the process chamber compared to the inward position.

A free volume of the process chamber is defined as the portion of the interior volume that is not occupied by any of the first, second and third bodies. The system is configured to limit a net rate of increase of the free volume of the process chamber when the first and second bodies move in a direction from the closed position towards the opened position faster than a predetermined threshold rate of movement. The limiting involves causing the third body to move in a direction from the outward position towards the inward position to at least partly compensate for a reduction of the occupancy of the interior volume by the first and second bodies as a result of their movements toward the opened position.

It has been found that in a conventional system, movement of the first and second bodies from the closed position to the opened position may cause a net increase in the free volume of the process chamber at such a rate that the gas supply is unable to compensate the resulting pressure drop sufficiently quickly, resulting in a temporary neutral pressure or underpressure in the process chamber compared to its environment. As an example, the movement of the first and second bodies may cause a significant increase in the free volume already within several tens of milliseconds, whereas a flow controller of a gas supply may have a settling time of several hundreds of milliseconds, i.e. being about an order of magnitude too slow for optimal compensation. Moreover, a sudden gas injection into the process chamber could lead to a turbulent flow, causing disadvantageous particle resuspension.

A neutral pressure or underpressure in the process chamber is undesirable as it may allow contaminants to enter the process chamber via insufficiently sealed gaps. As indicated above, perfect sealing is generally not feasible in view of the high temperatures involved. One way to avoid the neutral pressure or underpressure would be to normally maintain the process chamber at a relatively high overpressure, but this would then result is relatively high loss of expensive process gas, as also indicated above. Another possibility would be to reduce the speed at which the first and second bodies move from the closed position to the opened position, but this would increase the thermal budget of the wafer (i.e. its time at high temperature), resulting in a decrease in device performance due to deeper p/n junctions or destroyed functional layers after rapid thermal annealing. Moreover, this would result in a reduced overall processing speed or throughput rate, in turn resulting in higher production costs per wafer. A different solution is thus desired.

By causing a third body to move in a direction from the outward position towards the inward position to at least partly compensate for a reduction of the occupancy of the interior volume by the first and second bodies as a result of their movements towards the opened position, the net rate of increase of the free volume of the process chamber can advantageously be limited, e.g. to zero or at least a sufficiently low rate, so as to avoid neutral pressure or underpressure in the process chamber while the normal level of overpressure in the process chamber can be kept relatively low to help limit loss of process gas therefrom.

To avoid the neutral pressure or underpressure, the speed of the movement of the third body may be caused to match the movement speeds of the first and second bodies in the sense that the combined movements result in no or almost no net change of the free volume of the process chamber, or at least no or almost no net increase of the free volume. Compared to potential compensation by a gas supply, such compensation by a third body can be relatively quick, so that a desired low thermal budget of the wafer (i.e. short processing time at a given process temperature) can be achieved and a high throughput of wafers can be obtained using fast moving first and second bodies. It shall be appreciated that suitable movement speeds of the first, second and third bodies depend on volumetric properties of those bodies. For example, a movement of one volume at one speed may be compensated by an opposite movement of double such a volume at half such a speed, or by half such a volume at double such a speed, etc.

Preferably, to further help reduce loss of gas, a similar compensation approach is employed to prevent excessive overpressure in the process chamber, as will be explained further elsewhere herein.

Advantageously, as explained elsewhere herein, the third body may additionally provide and/or be utilized for one or more other functions. Furthermore, if desired, the third body could in practice be formed by a coordinated set of bodies, e.g. two or more bodies moving together between respective inward and outward positions. Nevertheless, to provide a relatively simple system design, it may be preferred that the third body is formed by a single body that is able to compensate for volume changes associated with movements of both the first and second bodies.

A further aspect provides a method of operating the system described herein, wherein, when the first and second bodies move in the direction from the closed position towards the opened position faster than the predetermined threshold rate of movement, the third body is caused to move in the direction from the outward position towards the inward position to at least partly compensate for the resulting reduction of the occupancy of the interior volume by the first and second bodies, wherein the net rate of increase of the free volume of the process chamber during the movement of the first and second bodies is limited at least in part by the movement of the third body.

Such a method provides advantages corresponding those described above regarding the system. The causing of the movement of the third body is preferably automatic by the system, for example by a controller jointly controlling the first, second and third bodies, and/or in response to a measurement of the movement of the first and second bodies.

A further aspect provides a method of operating the system as described herein, wherein, when the third body moves in a direction from the inward position towards the outward position faster than a predetermined threshold rate of movement, at least one of the first and second bodies is caused to move in a direction from the opened position towards the closed position to at least partly compensate for the resulting reduction in occupancy of the interior volume by the third body, wherein the net rate of increase of the free volume of the process chamber during the movement of the third body is limited at least in part by the movement of the at least one of the first and second bodies.

Such a method facilitates utilization of the third body for various other functions besides its compensation function as described above, e.g. a wafer transport function. When the first and/or second body thus compensates an occupancy change associated with a movement of the third body, overpressure in the process chamber can be maintained at a desired level without excessive loss of gas from the process chamber, also when the third body moves relatively fast. Similar to what has been described before, the causing of the movement of the first and/or second body is preferably automatic by the system.

A further aspect provides a method of treating an individual wafer manufactured from semiconductor material using the system as described herein, wherein the wafer is treated in the treatment area while the first and second bodies are in the closed position, wherein the system is operated as described herein after the treatment for removing the wafer from the treatment area, and preferably prior to the treatment for receiving the wafer in the treatment area from outside the process chamber.

Such a method provides above-described advantages.

As alluded to elsewhere herein, the system as described herein may comprise a controller operatively connected or connectable to the first, second and third bodies, and configured to control the movements of the bodies when connected. A further aspect provides a controller configured for use as the controller of the system, the controller being configured to automatically perform a method of operating the system as described herein during use as part of the system.

In use, such a controller provides above-described advantages. The controller could be comprised by an apparatus comprising the process chamber. Alternatively, the controller could be an external and/or remote controller, e.g. formed by a computer operatively connected to the process chamber, at least to the bodies or respective actuators. A combination is also possible, i.e. the controller may be distributed, e.g. comprising a master part formed by an external computer and a slave part comprised by an apparatus comprising the process chamber. The controller may be programmable, e.g. to configure one or more motion profiles for the movements of the bodies.

A further aspect provides a computer program product comprising computer readable instructions which, when executed by a computer, cause the computer to be configured as the controller as described herein, and/or to perform a method of operating the system as described herein during use as part of the system.

Such a computer program product provides above described advantages, in particular when running on a computer operatively connected to the bodies or respective actuators, e.g. a local and/or remote computer associated with the process chamber.

The aforementioned predetermined threshold rates of movement are preferably chosen or set relatively low, or even at zero, so that at most very slow movements that cannot lead to a neutral or negative pressure in the process chamber may be excluded from being compensated in the described way. It shall be appreciated that suitable values for such thresholds may thus be determined depending on various other system design parameters. Furthermore, it shall be appreciated that where the present disclosure indicates that a net rate of increase or decrease is limited, the actual net rate, e.g. as measured at that time, may in fact be zero or even negative. Thus, when a net rate of increase of a volume is limited, this merely implies that the volume does not increase faster than an imposed limit. Similarly, when a net rate of decrease of a volume is limited, this merely implies that the volume does not decrease faster than an imposed limit.

Optional advantageous elaborations are provided by the features of the dependent claims, as will be explained further in the detailed description below.

### DETAILED DESCRIPTION

In the following, the invention will be explained further using examples of embodiments and drawings. The drawings are schematic and merely show examples. In particular, the drawings may not be to scale and may not confer actual or proportional dimensions, areas, or volumes. In the drawings, corresponding elements have been provided with corresponding reference signs. In the drawings:
Fig. 1A shows a cross sectional side view of a system for treating an individual wafer, wherein first and second bodies are in a closed position and a third body is in an outward position;
Fig. 1B shows a cross sectional side view of the system of Fig. 1A, wherein the first and second bodies are in an opened position and the third body is in an inward position;
Fig. 2A shows a cross sectional side view of a system for treating an individual wafer, the system here comprising an airlock, wherein a third body is in an inward position ready to receive a wafer thereon from the airlock, wherein first and second bodies are in an opened position; and
Fig. 2B shows a cross sectional side view of the system of Fig. 2A, wherein the third body with the wafer thereon is in an outward position, wherein the first and second bodies are in a closed position.

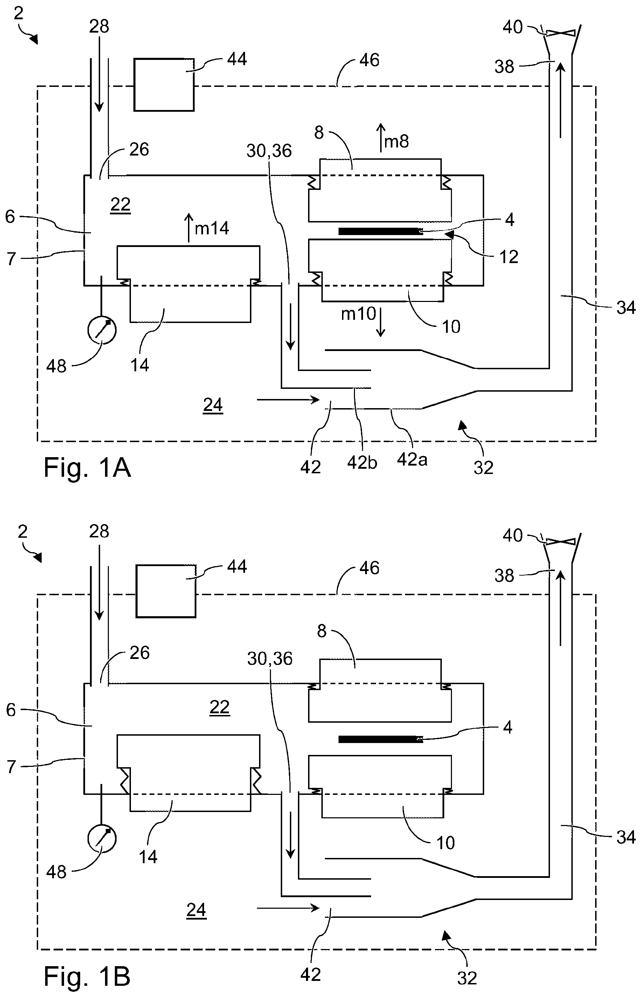

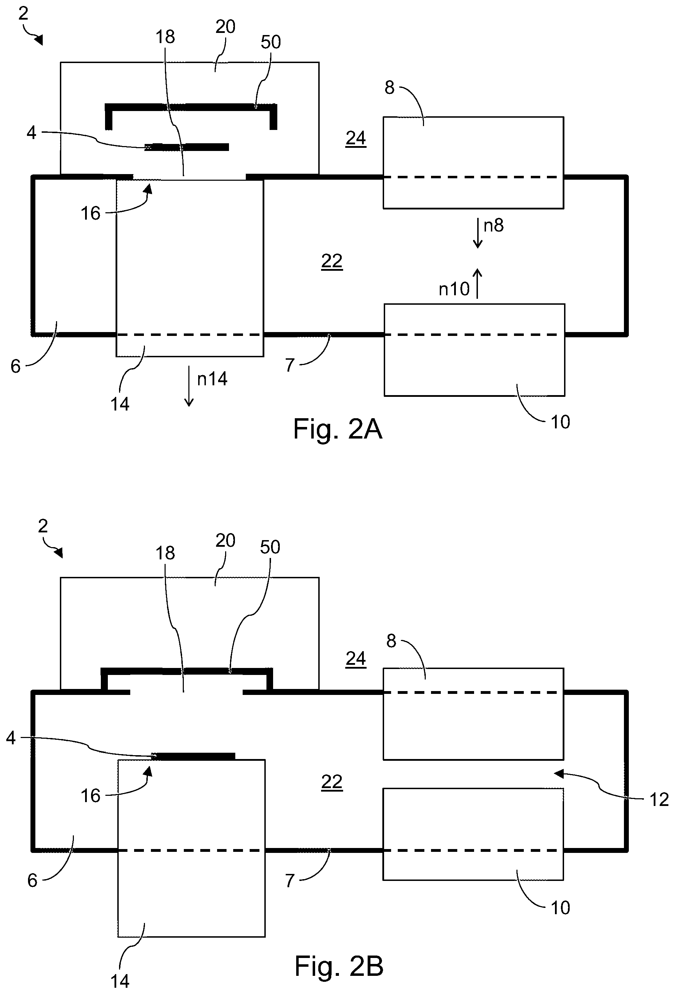

The figures show examples of a system 2 for treating an individual wafer 4 manufactured from semiconductor material. The system 2 comprises a process chamber 6 bound by a process chamber wall 7 defining an interior volume 22 of the process chamber 6. The process chamber 6 is provided with a first 8 and a second 10 body arranged for movably extending through the process chamber wall 7 to be movable away from each other from a closed position to an opened position, and towards each other from the opened position to the closed position. Closed positions are shown in Figs. 1A and 2B. Opened positions are shown in Figs. 1B and 2A.

In the closed position, a wafer 4 positioned in a treatment area 12 (see Fig. 1A) between the first and second bodies 8, 10 can be treated, in particular heated, via the first and second bodies 8, 10. The treatment area 12 may correspond to a treatment chamber formed within the process chamber 6 between the first and second bodies 8, 10 in the closed position. In the opened position, the wafer 4 can be moved into and out from the treatment area 12. In the opened position, the first and second bodies 8, 10 occupy less of the interior volume 22 of the process chamber 6 compared to the closed position.

The process chamber 6 is further provided with a third body 14 arranged for movably extending through the process chamber wall 7 to be movable between an inward position and an outward position. In the outward position, the third body14 occupies less of the interior volume 22 of the process chamber 6 compared to the inward position.

A free volume of the process chamber 6 is defined as the portion of the interior volume 22 that is not occupied by any of the first, second and third bodies 8, 10, 14. The free volume may thus be understood as the portion of the interior volume 22 that is effectively available for process gasses, which will generally tend to be at a same pressure throughout the free volume, the specific pressure depending on the amount of free volume, the amount of gas, and temperature. It shall be appreciated that the amount of gas may be varied relatively slowly by various factors including leaks due to imperfect sealing, by a gas supply 28, and by a gas outflow via an outlet 30, while the amount of free volume may be varied more quickly in particular by movements of the bodies 8, 10, 14.

The system 2 is configured to limit a net rate of increase of the free volume of the process chamber 6 when the first and second bodies 8, 10 move in a direction m8, m10 from the closed position towards the opened position faster than a predetermined threshold rate of movement.

The limiting of the net rate of increase of the free volume involves causing the third body 14 to move in a direction m14 from the outward position towards the inward position to at least partly compensate for a reduction of the occupancy of the interior volume by the first and second bodies 8, 10 as a result of their movements towards the opened position.

In Fig. 1A, the first and second bodies 8, 10 are shown in a closed position while the third body 14 is in an outward position. In Fig. 1B, the first and second bodies 8, 10 are shown in an opened position, having moved from the closed position along directions m8 and m10 as indicated in Fig. 1A. Meanwhile, the third body 14 is shown in Fig. 1B in an inward position, having moved from the outward position along direction m14 as indicated in Fig. 1A. To promote effective limitation of the net rate of increase of the free volume, the movement of the third body 14 is preferably substantially synchronized with the movements of the first and second bodies 8, 10. For example, when the first and second bodies 8, 10 move from the closed position to the opened position over a specific period of time, corresponding to a normal productive speed, the third body 14 preferably moves from the outward position to the inward position over substantially the same period of time, thus starting and ending the movement together in a synchronized manner. Small deviations in such timings may be acceptable as long as overpressure of the process chamber 6 is nevertheless maintained, preferably within predetermined limits as explained elsewhere herein. In traditional systems, other bodies are not moved or moved too slowly for effective volume compensation when the first and second bodies move at their relatively quickly normal productive speed.

Meanwhile, also to promote effective limitation of the net rate of increase of the free volume, dimensions of the bodies 8, 10, 14 and distances between their aforementioned positions are preferably chosen so that a free volume increase enabled by reduced occupancy by the first and second bodies 8, 10 in opened position is matched by a substantially equal free volume decrease from increased occupancy by the third body 14 in inward position. In other words, the system 2 is preferably dimensioned such that the change in free volume enabled by the combined movements of the first and second bodies 8, 10 is matched by the change in free volume enabled by the movement of the third body 14, so that both changes in free volume can cancel each other out when the synchronized respective movements are in mutually opposite directions with respect to the process chamber 6. Although not strictly necessary, the movements of the bodies 8, 10, 14 are preferably controlled by a same controller 44.

In embodiments, for the at least partly compensating for the reduction of the occupancy of the interior volume 22 by the first and second bodies 8, 10, the system 2 is configured to move the third body 14 towards the inward position according to a respective predetermined motion profile when the first and second bodies 8, 10 move towards the opened position according to a respective predetermined motion profile.

Such motion profiles enable a relatively simple yet effective control of the bodies 8, 10, 14 for the volume compensation. In the present context, a motion profile can be understood as a specification of two or more positions, speeds and/or accelerations with associated timing, for example a starting position with a starting time and an end position with an end time, optionally complemented by specifications of intermediate positions and/or speeds and/or accelerations and their timings. In one example of a motion profile, a body is first accelerated to depart from an initial position and subsequently decelerated to arrive at a destination position, optionally moving at a constant speed in between. It shall be appreciated that excessive accelerations are preferably avoided. Such a motion profile can be effected by a suitable actuator (not shown), in particular when controlled by the controller 44.

In embodiments, with reference to Figs. 2A-B, the third body 14 is configured for moving a wafer 4 into the process chamber 6 by movement of the third body 14 from the inward position (shown in Fig. 2A) towards, e.g. to, the outward position (shown in Fig. 2B), wherein in the inward position a wafer receiving end 16 of the third body 14 is arranged at an openable and closeable wafer loading opening 18 in the process chamber wall 7.

Thereby, the third body 14 can advantageously provide additional functionality besides the described volume compensation. From the situation in Fig. 2B, the wafer 4 may subsequently be moved by a suitable wafer handling device (not shown) to a treatment area 12 between the first and second bodies 8, 10. For clarity of the drawings, the wafer loading opening 18 and associated structures 20, 50 are not shown in Figs. 1A-B, although they may be correspondingly applied there. Similarly, various elements shown in Figs. 1A-B are not shown in Figs. 2A-B, although they may be correspondingly applied there.

In embodiments, with continued reference to Figs. 2A-B, the system comprises an airlock 20 outside the process chamber 6 for loading a wafer 4 into the process chamber 6 via the airlock 20, wherein the wafer loading opening 18, when opened, connects the interior volume 22 of the process chamber 6 to an interior of the airlock 20.

Such an airlock 20 can advantageously help to maintain the overpressure of the process chamber 6 when a wafer 4 is moved into or out of the process chamber 6. The airlock 20 here comprises a door 50 configured to close off the wafer loading opening 18 that here connects the interior of the airlock 20 with the interior of the process chamber 6 when open, and a further door (not shown) configured to close off an opening (not shown) between the interior of the airlock 20 and an exterior space 24. When its doors are closed, pressure in the interior of the airlock 20 can be controlled to selectively match either a pressure in the process chamber 6 or a pressure in the exterior space 24, so that a wafer 4 can be moved between the lower pressure exterior space 24 and the higher pressure process chamber 6 substantially without loss of pressure from the process chamber 6. In Fig. 2B it can be seen that the door 50 has been moved to close off the opening 18 after the wafer 4 has been moved into the process chamber 6.

In embodiments, the third body 14, in particular a wafer receiving end 16 thereof, is configured to cool a wafer 4 in the process chamber 6.

Thereby, the third body 14 can advantageously provide additional functionality besides the described volume compensation and optionally the described wafer movement. Wafer cooling may for example be performed after the wafer 4 has been heated in the treatment area 12, before the wafer 4 is moved out of the process chamber 6.

In embodiments, with reference to Figs. 2A-B, the system 2 is configured to limit a net rate of increase of the free volume of the process chamber 6 when the third body 14 moves in a direction n14 from the inward position towards the outward position faster than a predetermined threshold rate of movement, wherein the limiting involves causing at least one of the first and second bodies 8, 10 to move in a direction n8, n10 from the opened position towards the closed position to at least partly compensate for a reduction of the occupancy of the interior volume 22 by the third body 14 as a result of its movement towards the outward position.

Advantages obtained thereby essentially correspond to those described above regarding volume compensation of the movements of the first and second bodies 8, 10 by movement of the third body14, with the main difference being that the primary motion, i.e. the reason that motion is required in the first place, is in this case by the third body 14 as opposed to by the first and second bodies 8, 10. In practice, these two types of compensation may be mutually indistinguishable based on only the motions of the bodies 8, 10, 14 themselves. A distinction may however be present in the manner in which the bodies 8, 10, 14 are controlled, wherein for example either the first and second bodies 8, 10 or the third body 14 can be regarded as a 'primary mover' while the other body/bodies may be regarded as 'compensator'. However, it is also possible that the movements of the bodies 8, 10, 14 are more or less strictly coupled, e.g. by programming of a joint controller, so that one cannot be moved without compensatory movement of the other. In other words, the described compensations may be in some embodiments be regarded as mutual compensations that are effected more or less intrinsically. In the latter scenario, the distinction between a 'primary mover' and a 'compensator' may be mainly semantic, e.g. depending on which body/bodies is/are used for a function other than volume compensation at that time.

In embodiments, for the at least partly compensating for the reduction of the occupancy of the interior volume 22 by the third body 14, the system 2 is configured to move at least one of the first and second bodies towards the closed position 8, 10 according to a respective predetermined motion profile when the third body 14 moves towards the outward position according to a respective predetermined motion profile.

Advantages of such motion profiles have been described above, and apply here correspondingly.

In embodiments, the system 2 is configured to at least selectively maintain the free volume of the process chamber 6 at an overpressure with respect to an exterior 24 of the process chamber 6, at least partly by movement of one or more of the first, second and third bodies 8, 10, 14.

Advantages of such overpressure have been described above. Besides the movements of the bodies 8, 10, 14, a rate of a gas supply 28 and/or an outflow rate towards a gas exhaust (see e.g. gas outlet 30, exhaust channel 34) typically also influence the maintenance of such an overpressure, although generally more slowly than the possibly fast movements of the bodies 8, 10, 14. Thus, by maintaining the overpressure at least partly by the movement of the bodies 8, 10, 14, tighter pressure control is enabled, in particular for when occupancy of the interior volume 22 of the process chamber 6 is changed by required movements of the bodies 8, 10, 14 such as for wafer handling.

In embodiments, the system 2 is configured to limit the overpressure of the process chamber 6 to at most 40 mbar, preferably at most 20 mbar, more preferably at most 10 mbar, more preferably at most about 5 mbar.

Thereby, excessive loss of gas from the process chamber 6 can be prevented while still sufficient overpressure can be provided to inhibit entry of contaminants. For example, a lower limit of 3 mbar, 2 mbar or 1 mbar may be applied for the overpressure for sufficient inhibition of contaminant entry.

In embodiments, the first and second bodies 8, 10 in the closed position are configured to heat a wafer 4 in the treatment area 12 for annealing of the semiconductor material. The annealing may involve and/or amount to so-called rapid thermal annealing (RTA).

Such a heating function of the first and second bodies 8, 10 is known as such and is preferably correspondingly employed here. For advantageous positioning of and heat transfer to the wafer 4, the first and second bodies 8, 10 may cause the wafer 4 to float therebetween by a supply of gas via wafer facing surfaces of the first and/or second bodies 8, 10, as is also known as such.

In embodiments, with reference to Figs. 1A-B, the process chamber 6 is provided with a gas inlet 26 connectable or connected to a gas supply 28 and a gas outlet 30 connectable or connected to an exhaust assembly 32. In embodiments, including in the shown example, the system 2 comprises the exhaust assembly 32.

Gas inlets and outlets are known as such for process chambers and may be correspondingly applied here, in particular to supply and/or remove so-called process gasses, and/or to help maintain the desired overpressure of the process chamber 6 with respect to its environment 24.

In embodiments, with continued reference to Figs. 1A-B, the exhaust assembly 32 comprises an exhaust channel 34 having an exhaust channel inlet end 36 for connection to the gas outlet 30 of the process chamber 6 and an exhaust channel outlet end 38 for connection to an exhaust fan 40, e.g. of a factory exhaust, wherein the exhaust channel 34 comprises an intermediate inlet 42 between the exhaust channel inlet end 36 and the exhaust channel outlet end 38.

The intermediate inlet 42 is configured to allow air from an exterior 24 of the process chamber 6, e.g. from within an enclosure 46 such as a cabinet having an open connection with a clean room environment, to be drawn into the exhaust channel 34 by the exhaust fan 40. Advantageously, upstream transmission of pressure fluctuations from the exhaust channel outlet end 38 to the exhaust channel inlet end 36 via the exhaust channel 34 can thereby be dampened. Such fluctuations could otherwise affect the desired tight control of the overpressure of the process chamber 6. For example, when pressure at the outlet end 38 is momentarily decreased, instead of resulting in a corresponding pressure drop in the process chamber 6, more air may be automatically drawn in via the intermediate inlet 42 while outflow via the gas outlet 30 of the pressure chamber 6 can remain relatively steady. Pressure fluctuations at the exhaust channel outlet end 38 may occur for various reasons, for example due to the operation of other equipment being connected to a same factory exhaust, here at exhaust fan 40.

Although the rate of air drawn in via the intermediate inlet 42 preferably fluctuates automatically with pressure fluctuations at the outlet end 38 as described, an adjustment of said rate may additionally be enabled, e.g. by manual or automatic adjustment of a flow resistance associated with the intermediate inlet 42.

In the shown examples, the intermediate inlet 42 is provided by an arrangement of relatively wide open ended downstream channel section 42a overlapping in axial direction with a relatively narrow open ended upstream channel section 42b, as indicated in Fig. 1A, so that the wider section 42a draws in gas flowing out of the narrower section 42b as well as drawing in air via the here circumferential intermediate inlet 42 that is formed radially between the sections 42a, 42b. Relatively smooth flows can be obtained thereby, wherein the inflow rate through the intermediate inlet 42 may be adjustable by manually and/or automatically adjusting the axial overlap between the sections 42a, 42b to adjust an effective flow resistance through the intermediate inlet 42. Alternatively or additionally, one or more valves (not shown) could be arranged at the intermediate inlet 42 for adjustment of flow resistance through the intermediate inlet 42.

In embodiments, the system 2 is configured to at least selectively limit an overpressure of the free volume of the process chamber 6 with respect to an exterior 24 of the process chamber 6, at least partly by movement of one or more of the first, second and third bodies 8, 10, 14.

Whereas above it has been described how movements of the bodies 8, 10, 14 can help to maintain such an overpressure, it is noted here that such movements may at the same time help to limit the maintained overpressure, in particular so as to prevent excessive overpressure. The limiting of the overpressure can be realized in various ways, but generally involves compensation of body movements that can potentially increase the overpressure (namely by reducing the free volume of the process chamber 6 if not compensated) by other body movements that can effectively compensate such for such a pressure increase (namely by allowing a corresponding increase of the free volume of the process chamber 6). More specific scenarios are outlined below.

In embodiments, with reference to Figs. 2A-B, the system 2 is configured to limit a net rate of decrease of the free volume of the process chamber 6 when the first and second bodies 8, 10 move in a direction n8, n10 from the opened position towards the closed position faster than a predetermined threshold rate of movement, wherein the limiting involves causing the third body 14 to move in a direction n14 from the inward position towards the outward position to at least partly compensate for an increase of the occupancy of the interior volume 22 by the first and second bodies 8, 10 as a result of their movements towards the closed position.

In embodiments, with reference to Figs. 1A-B, the system 2 is configured to limit a net rate of decrease of the free volume of the process chamber 6 when the third body 14 moves in a direction m14 from the outward position towards the inward position faster than a predetermined threshold rate of movement, wherein the limiting involves causing at least one of the first and second bodies 8, 10 to move in a direction m8, m10 from the closed position towards the opened position to at least partly compensate for an increase of the occupancy of the interior volume 22 by the third body 14 as a result of its movement towards the inward position.

As indicated elsewhere herein, the movements of the bodies 8, 10, 14 may be mutually coupled, in which case both the maintaining and the limiting of the overpressure could be realized more or less intrinsically thereby, in particular in combination with control of a gas supply 28 and a gas exhaust (e.g. via gas outlet 30). Alternatively, control of the bodies 8, 10, 14 could be more complex, in which case the maintaining and/or limiting of the overpressure could be less dependent on the gas supply and/or exhaust, and could generally be more robust against disturbances. Such a more complex control could for example involve one or more feedback control loops, e.g. running on a controller 44, whereby the movements of the bodies 8, 10, 14 at least partly depend on readings from a pressure sensor 48. In a simpler form of control, control of the bodies 8, 10, 14 is not dependent on the pressure sensor 48. The pressure sensor 48 may then for example be used only to help control the gas supply 28 and/or for monitoring purposes.

In embodiments, with reference to Figs. 1A-B and as alluded to elsewhere herein, the system 2 comprises a controller 44 operatively connected or connectable to the first, second and bodies 8, 10, 14, and configured to control the movements of the bodies 8, 10, 14 when connected. For clarity of the drawings, connections to and/or from the controller 44 are not shown in Figs. 1A-B. The connections may be wired and/or wireless connections, although wired connections may be preferred for reliability and speed.

In a method of operation of the system 2, when the first and second bodies 8, 10 move in the direction m8, m10 from the closed position towards the opened position faster than the predetermined threshold rate of movement, the third body 14 is caused to move in the direction m14 from the outward position towards the inward position to at least partly compensate for the resulting reduction of the occupancy of the interior volume 22 by the first and second bodies 8, 10, wherein the net rate of increase of the free volume of the process chamber 6 during the movement of the first and second bodies 8, 10 is limited at least in part by the movement of the third body 14.

Alternatively or additionally, when the third body 14 moves in the direction n14 from the inward position towards the outward position faster than the respective predetermined threshold rate of movement, at least one of the first and second bodies 8, 10 is caused to move in the direction n8, n10 from the opened position towards the closed position to at least partly compensate for the resulting reduction in occupancy of the interior volume 22 by the third body 14, wherein the net rate of increase of the free volume of the process chamber 6 during the movement of the third body 14 is limited at least in part by the movement of the at least one of the first and second bodies 8, 10.

In a method of treating an individual wafer 4 manufactured from semiconductor material using the system 2, the wafer 4 is treated in the treatment area 12 while the first and second bodies 8, 10 are in the closed position.

In embodiments, after the treatment, for removing the wafer 4 from the treatment area 12, the system 2 is operated as described herein when the first and second bodies 8, 10 move in the direction m8, m10 from the closed position towards the opened position faster than the predetermined threshold rate of movement.

In embodiments, prior to the treatment, for receiving the wafer 4 in the treatment area 12 from outside the process chamber 6, the system 2 is operated as described herein when the third body 14 moves in the direction n14 from the inward position towards the outward position faster than the predetermined threshold rate of movement.

The figures also show a controller 44 configured for use as the controller 44 of the system 2, the controller 44 being configured to automatically perform a method as described herein during use as part of the system 2. The controller 44 may be realized by a computer provided with a computer program product comprising computer readable instructions which, when executed by the computer, cause the computer to be configured as the controller 44 as described herein.

Although the invention has been explained herein using examples of embodiments and drawings, these do not limit the scope of the invention as defined by the claims. Many variations, combinations and extensions are possible, as will be appreciated by the skilled person having the benefit of the present disclosure. Examples thereof have been provided throughout the description. All such variants are included within the scope of the invention as defined by the claims.

### LIST OF REFERENCE SIGNS

- 2.: System
- 4.: Wafer
- 6.: Process chamber
- 7.: Process chamber wall
- 8.: First body
- 10.: Second body
- 12.: Treatment area
- 14.: Third body
- 16.: Wafer receiving end of third body
- 18.: Wafer loading opening
- 20.: Airlock
- 22.: Interior volume of process chamber
- 24.: Exterior of process chamber
- 26.: Gas inlet
- 28.: Gas supply
- 30.: Gas outlet
- 32.: Exhaust assembly
- 34.: Exhaust channel
- 36.: Exhaust channel inlet end
- 38.: Exhaust channel outlet end
- 40.: Exhaust fan
- 42.: Intermediate inlet
- 44.: Controller
- 46.: Enclosure
- 48.: Pressure sensor
- 50.: Door
- m8.: Movement direction of first body from closed position towards opened position
- m10.: Movement direction of second body from closed position towards opened position
- m14.: Movement direction of third body from outward position towards inward position
- n8.: Movement direction of first body from opened position towards closed position
- n10.: Movement direction of second body from opened position towards closed position
- n14.: Movement direction of third body from inward position towards outward position

## Claims

1. A system (2) for treating an individual wafer (4) manufactured from semiconductor material, comprising a process chamber (6) bound by a process chamber wall (7) defining an interior volume (22) of the process chamber (6), wherein the process chamber (6) is provided with a first (8) and a second (10) body arranged for movably extending through the process chamber wall (7) to be movable away from each other from a closed position to an opened position, and towards each other from the opened position to the closed position, wherein in the closed position a wafer (4) positioned in a treatment area (12) between the first and second bodies (8, 10) can be treated via the first and second bodies (8, 10), wherein in the opened position the wafer (4) can be moved into and out from the treatment area (12), wherein in the opened position the first and second bodies (8, 10) occupy less of the interior volume (22) of the process chamber (6) compared to the closed position,
wherein the process chamber (6) is further provided with a third body (14) arranged for movably extending through the process chamber wall (7) to be movable between an inward position and an outward position, wherein in the outward position the third body (14) occupies less of the interior volume (22) of the process chamber (6) compared to the inward position,
wherein a free volume of the process chamber (6) is defined as the portion of the interior volume (22) that is not occupied by any of the first, second and third bodies (8, 10, 14), wherein the system (2) is configured to limit a net rate of increase of the free volume of the process chamber (6) when the first and second bodies (8, 10) move in a direction (m8, m10) from the closed position towards the opened position faster than a predetermined threshold rate of movement, wherein the limiting involves causing the third body (14) to move in a direction (m14) from the outward position towards the inward position to at least partly compensate for a reduction of the occupancy of the interior volume (22) by the first and second bodies (8, 10) as a result of their movements towards the opened position.

2. The system according to claim 1, wherein:
- for the at least partly compensating for the reduction of the occupancy of the interior volume (22) by the first and second bodies (8, 10), the system (2) is configured to move the third body (14) towards the inward position according to a respective predetermined motion profile when the first and second bodies (8, 10) move towards the opened position according to a respective predetermined motion profile; and/or
- the third body (14) is configured for moving a wafer (4) into the process chamber (6) by movement of the third body (14) from the inward position towards the outward position, wherein in the inward position a wafer receiving end (16) of the third body (14) is arranged at an openable and closeable wafer loading opening (18) in the process chamber wall (7),
wherein the system preferably comprises an airlock (20) outside the process chamber (6) for loading a wafer (4) into the process chamber (6) via the airlock (20), wherein the wafer loading opening (18), when opened, connects the interior volume (22) of the process chamber (6) to an interior of the airlock (20).

3. The system according to any of the preceding claims, wherein the third body (14) is configured to cool a wafer (4) in the process chamber (6).

4. The system according to any of the preceding claims, wherein the system (2) is configured to limit a net rate of increase of the free volume of the process chamber (6) when the third body (14) moves in a direction (n14) from the inward position towards the outward position faster than a predetermined threshold rate of movement, wherein the limiting involves causing at least one of the first and second bodies (8, 10) to move in a direction (n8, n10) from the opened position towards the closed position to at least partly compensate for a reduction of the occupancy of the interior volume (22) by the third body (14) as a result of its movement towards the outward position,
preferably wherein, for the at least partly compensating for the reduction of the occupancy of the interior volume (22) by the third body (14), the system (2) is configured to move at least one of the first and second bodies (8, 10) towards the closed position according to a respective predetermined motion profile when the third body (14) moves towards the outward position according to a respective predetermined motion profile.

5. The system according to any of the preceding claims, configured to at least selectively maintain the free volume of the process chamber (6) at an overpressure with respect to an exterior (24) of the process chamber (6), at least partly by movement of one or more of the first, second and third bodies (8, 10, 14),
preferably wherein the system (2) is configured to limit the overpressure to at most 40 mbar, preferably at most 20 mbar, more preferably at most 10 mbar, more preferably at most about 5 mbar.

6. The system according to any of the preceding claims, wherein the first and second bodies (8, 10) in the closed position are configured to heat a wafer (4) in the treatment area (12) for annealing of the semiconductor material.

7. The system according to any of the preceding claims, wherein the process chamber (6) is provided with a gas inlet (26) connectable or connected to a gas supply (28) and a gas outlet (30) connectable or connected to an exhaust assembly (32),
wherein the system preferably comprises the exhaust assembly (32), the exhaust assembly (32) comprising an exhaust channel (34) having an exhaust channel inlet end (36) for connection to the gas outlet (30) of the process chamber (6) and an exhaust channel outlet end (38) for connection to an exhaust fan (40), wherein the exhaust channel (34) comprises an intermediate inlet (42) between the exhaust channel inlet end (36) and the exhaust channel outlet end (38), the intermediate inlet (42) being configured to allow air from an exterior (24) of the process chamber (6) to be drawn into the exhaust channel (34) by the exhaust fan (40) so as to dampen upstream transmission of pressure fluctuations from the exhaust channel outlet end (38) to the exhaust channel inlet end (36) via the exhaust channel (34).

8. The system according to any of the preceding claims, configured to at least selectively limit an overpressure of the free volume of the process chamber (6) with respect to an exterior (24) of the process chamber (6), at least partly by movement of one or more of the first, second and third bodies (8, 10, 14).

9. The system according to any of the preceding claims, wherein:
- the system (2) is configured to limit a net rate of decrease of the free volume of the process chamber (6) when the first and second bodies (8, 10) move in a direction from the opened position towards the closed position faster than a predetermined threshold rate of movement, wherein the limiting involves causing the third body (14) to move in a direction from the inward position towards the outward position to at least partly compensate for an increase of the occupancy of the interior volume (22) by the first and second bodies (8, 10) as a result of their movements towards the closed position; and/or
- the system (2) is configured to limit a net rate of decrease of the free volume of the process chamber (6) when the third body (14) moves in a direction from the outward position towards the inward position faster than a predetermined threshold rate of movement, wherein the limiting involves causing at least one of the first and second bodies (8, 10) to move in a direction from the closed position towards the opened position to at least partly compensate for an increase of the occupancy of the interior volume (22) by the third body (14) as a result of its movement towards the inward position.

10. The system according to any of the preceding claims, comprising a controller (44) operatively connected or connectable to the first, second and third bodies (8, 10, 14), and configured to control the movements of the bodies (8, 10, 14) when connected.

11. A method of operating the system (2) according to any of the preceding claims, wherein, when the first and second bodies (8, 10) move in the direction (m8, m10) from the closed position towards the opened position faster than the predetermined threshold rate of movement, the third body (14) is caused to move in the direction (n14) from the outward position towards the inward position to at least partly compensate for the resulting reduction of the occupancy of the interior volume (22) by the first and second bodies (8, 10), wherein the net rate of increase of the free volume of the process chamber (6) during the movement of the first and second bodies (8, 10) is limited at least in part by the movement of the third body (14).

12. A method, preferably according to claim 11, of operating the system (2) according to any of claims 4 - 10, wherein, when the third body (14) moves in the direction (n14) from the inward position towards the outward position faster than the respective predetermined threshold rate of movement, at least one of the first and second bodies (8, 10) is caused to move in the direction (n8, n10) from the opened position towards the closed position to at least partly compensate for the resulting reduction in occupancy of the interior volume (22) by the third body (14), wherein the net rate of increase of the free volume of the process chamber (6) during the movement of the third body (14) is limited at least in part by the movement of the at least one of the first and second bodies (8, 10).

13. A method of treating an individual wafer (4) manufactured from semiconductor material using the system (2) according to any of claims 1 - 10, wherein the wafer (4) is treated in the treatment area (12) while the first and second bodies (8, 10) are in the closed position, wherein the system (2) is operated according to claim 17 after the treatment for removing the wafer (4) from the treatment area (12),
preferably wherein the system (2) is configured according to any of claims 4 - 10 and is operated according to claim 12 prior to the treatment for receiving the wafer (4) in the treatment area (12) from outside the process chamber (6).

14. A controller (44) configured for use as the controller (44) of the system (2) according to claim 10, configured to automatically perform the method according to claim 11 or 12 during use as part of the system (2).

15. A computer program product comprising computer readable instructions which, when executed by a computer, cause the computer to be configured as a controller (44) according to claim 14.

## Patentansprüche

1. System (2) zur Behandlung eines einzelnen, aus Halbleitermaterial hergestellten Wafers (4), welches eine Prozesskammer (6) umfasst, die von einer Prozesskammerwand (7) begrenzt wird, welche ein Innenvolumen (22) der Prozesskammer (6) bildet, wobei die Prozesskammer (6) mit einem ersten (8) und einem zweiten (10) Körper versehen ist, die so angeordnet sind, dass sie sich beweglich durch die Prozesskammerwand (7) erstrecken und aus einer geschlossenen Position in eine geöffnete Position voneinander weg und aus der geöffneten Position in die geschlossene Position aufeinander zu bewegbar sind, wobei in der geschlossenen Position ein in einem Behandlungsbereich (12) zwischen dem ersten und dem zweiten Körper (8, 10) positionierter Wafer (4) über den ersten und den zweiten Körper (8, 10) behandelt werden kann, wobei in der geöffneten Position der Wafer (4) in den Behandlungsbereich (12) hinein- und aus diesem herausbewegt werden kann, wobei in der geöffneten Position der erste und der zweite Körper (8, 10) im Vergleich zur geschlossenen Position einen geringeren Teil des Innenvolumens (22) der Prozesskammer (6) belegen,
wobei die Prozesskammer (6) ferner mit einem dritten Körper (14) versehen ist, der so angeordnet ist, dass er sich beweglich durch die Prozesskammerwand (7) erstreckt, um zwischen einer Innenposition und einer Außenposition bewegbar zu sein, wobei der dritte Körper (14) in der Außenposition im Vergleich zur Innenposition einen geringeren Teil des Innenvolumens (22) der Prozesskammer (6) belegt,
wobei ein freies Volumen der Prozesskammer (6) als der Teil des Innenvolumens (22) definiert ist, der nicht von einem der ersten, zweiten und dritten Körper (8, 10, 14) eingenommen wird, wobei das System (2) so konfiguriert ist, dass es eine Nettozunahmerate des freien Volumens der Prozesskammer (6) begrenzt, wenn sich der erste und der zweite Körper (8, 10) in einer Richtung (m8, m10) von der geschlossenen Position in Richtung der geöffneten Position schneller als eine vorbestimmte Schwellenbewegungsgeschwindigkeit bewegen, wobei die Begrenzung beinhaltet, den dritten Körper (14) dazu zu veranlassen, sich in einer Richtung (m14) von der Außenposition in Richtung der Innenposition zu bewegen, um eine Verringerung der Belegung des Innenvolumens (22) durch den ersten und den zweiten Körper (8, 10) infolge ihrer Bewegungen in Richtung der geöffneten Position zumindest teilweise auszugleichen.

2. System nach Anspruch 1, wobei:
um die Verringerung der Belegung des Innenvolumens (22) durch den ersten und den zweiten Körper (8, 10) zumindest teilweise auszugleichen, das System (2) so ausgelegt ist, dass es den dritten Körper (14) gemäß einem jeweiligen vorgegebenen Bewegungsprofil in Richtung der Innenposition bewegt, wenn sich der erste und der zweite Körper (8, 10) gemäß einem jeweiligen vorgegebenen Bewegungsprofil in Richtung der geöffneten Position bewegen; und/oder
der dritte Körper (14) so ausgelegt ist, dass er einen Wafer (4) durch eine Bewegung des dritten Körpers (14) von der Innenposition in Richtung der Außenposition in die Prozesskammer (6) bewegt, wobei in der Innenposition ein Waferaufnahmeende (16) des dritten Körpers (14) an einer öffenbaren und schließbaren Wafer-Ladeöffnung (18) in der Prozesskammerwand (7) angeordnet ist,
wobei das System vorzugsweise eine Schleuse (20) außerhalb der Prozesskammer (6) umfasst, um einen Wafer (4) über die Schleuse (20) in die Prozesskammer (6) einzuführen, wobei die Wafer-Ladeöffnung (18) im geöffneten Zustand das Innenvolumen (22) der Prozesskammer (6) mit dem Innenraum der Schleuse (20) verbindet.

3. System nach einem der vorstehenden Ansprüche, wobei der dritte Körper (14) dazu ausgelegt ist, einen Wafer (4) in der Prozesskammer (6) zu kühlen.

4. System nach einem der vorstehenden Ansprüche, wobei das System (2) so ausgelegt ist, dass es eine Nettozunahmerate des freien Volumens der Prozesskammer (6) begrenzt, wenn sich der dritte Körper (14) in einer Richtung (n14) von der Innenposition in Richtung der Außenposition schneller als eine vorbestimmte Schwellenbewegungsgeschwindigkeit bewegt, wobei die Begrenzung beinhaltet, dass mindestens einer der ersten und zweiten Körper (8, 10) veranlasst wird, sich in einer Richtung (n8, n10) von der geöffneten Position in Richtung der geschlossenen Position zu bewegen, um eine Verringerung der Belegung des Innenvolumens (22) durch den dritten Körper (14) infolge seiner Bewegung in Richtung der Außenposition zumindest teilweise auszugleichen,
vorzugsweise wobei, um die Verringerung der Belegung des Innenvolumens (22) durch den dritten Körper (14) zumindest teilweise auszugleichen, das System (2) so ausgelegt ist, dass es zumindest einen der ersten und zweiten Körper (8, 10) gemäß einem jeweiligen vorgegebenen Bewegungsprofil in Richtung der geschlossenen Position bewegt, wenn sich der dritte Körper (14) gemäß einem jeweiligen vorgegebenen Bewegungsprofil in Richtung der Außenposition bewegt.

5. System nach einem der vorstehenden Ansprüche, das so ausgelegt ist, dass es das freie Volumen der Prozesskammer (6) zumindest selektiv auf einem Überdruck gegenüber einem Außenbereich (24) der Prozesskammer (6) hält, zumindest teilweise durch die Bewegung eines oder mehrerer der ersten, zweiten und dritten Körper (8, 10, 14),
vorzugsweise wobei das System (2) so ausgelegt ist, dass der Überdruck auf höchstens 40 mbar, vorzugsweise auf höchstens 20 mbar, noch bevorzugter auf höchstens 10 mbar und noch bevorzugter auf höchstens etwa 5 mbar begrenzt wird.

6. System nach einem der vorstehenden Ansprüche, wobei der erste und der zweite Körper (8, 10) in der geschlossenen Position so ausgelegt sind, dass sie einen Wafer (4) im Behandlungsbereich (12) zum Tempern des Halbleitermaterials erwärmen.

7. System nach einem der vorstehenden Ansprüche, wobei die Prozesskammer (6) mit einem Gaseinlass (26), der mit einer Gasversorgung (28) verbindbar oder verbunden ist, und mit einem Gasauslass (30), der mit einer Abluftvorrichtung (32) verbindbar oder verbunden ist, versehen ist,
wobei das System vorzugsweise die Abluftvorrichtung (32) umfasst, wobei die Abluftvorrichtung (32) einen Abluftkanal (34) umfasst, der ein Abluftkanal-Einlassende (36) zum Anschluss an den Gasauslass (30) der Prozesskammer (6) und ein Abluftkanal-Auslassende (38) zum Anschluss an einen Abluftventilator (40) aufweist, wobei der Abluftkanal (34) einen Zwischeneinlass (42) zwischen dem Abluftkanal-Einlassende (36) und dem Abluftkanal-Auslassende (38) umfasst, wobei der Zwischeneinlass (42) so ausgebildet ist, dass Luft aus einem Außenbereich (24) außerhalb der Prozesskammer (6) durch den Abluftventilator (40) in den Abluftkanal (34) gesaugt werden kann, um die stromaufwärtige Übertragung von Druckschwankungen vom Abluftkanal-Auslassende (38) zum Abluftkanal-Einlassende (36) über den Abluftkanal (34) zu dämpfen.

8. System gemäß einem der vorstehenden Ansprüche, das so ausgelegt ist, dass es einen Überdruck des freien Volumens der Prozesskammer (6) gegenüber einem Außenbereich (24) der Prozesskammer (6) zumindest selektiv begrenzt, zumindest teilweise durch die Bewegung eines oder mehrerer der ersten, zweiten und dritten Körper (8, 10, 14).

9. System nach einem der vorstehenden Ansprüche, wobei:
das System (2) so ausgelegt ist, dass es die Nettoabnahmerate des freien Volumens der Prozesskammer (6) begrenzt, wenn sich der erste und der zweite Körper (8, 10) schneller als mit einer vorgegebenen Schwellenbewegungsgeschwindigkeit in Richtung von der geöffneten Position zur geschlossenen Position bewegen, wobei die Begrenzung beinhaltet, dass der dritte Körper (14) veranlasst wird, sich in Richtung von der Innenposition zur Außenposition zu bewegen, um eine Zunahme der Belegung des Innenvolumens (22) durch den ersten und den zweiten Körper (8, 10) infolge ihrer Bewegungen in Richtung der geschlossenen Position zumindest teilweise auszugleichen; und/oder
das System (2) so ausgelegt ist, dass es die Nettoabnahmerate des freien Volumens der Prozesskammer (6) begrenzt, wenn sich der dritte Körper (14) in Richtung von der Außenposition zur Innenposition schneller bewegt als eine vorgegebene Schwellenbewegungsgeschwindigkeit, wobei die Begrenzung das Veranlassen beinhaltet, dass sich mindestens einer der ersten und zweiten Körper (8, 10) in einer Richtung von der geschlossenen Position in Richtung der geöffneten Position bewegt, um eine Zunahme der Belegung des Innenvolumens (22) durch den dritten Körper (14) infolge seiner Bewegung in Richtung der Innenposition zumindest teilweise auszugleichen.

10. System gemäß einem der vorstehenden Ansprüche, welches eine Steuerung (44) umfasst, die funktionsmäßig mit dem ersten, dem zweiten und dem dritten Körper (8, 10, 14) verbunden oder verbindbar ist und so ausgelegt ist, dass sie die Bewegungen der Körper (8, 10, 14) steuert, wenn eine Verbindung besteht.

11. Verfahren zum Betreiben des Systems (2) gemäß einem der vorstehenden Ansprüche, wobei, wenn sich der erste und der zweite Körper (8, 10) in Richtung (m8, m10) von der geschlossenen Position in Richtung der geöffneten Position schneller als mit der vorgegebenen Schwellenbewegungsgeschwindigkeit bewegen, der dritte Körper (14) veranlasst wird, sich in Richtung (n14) von der Außenposition in Richtung der Innenposition zu bewegen, um die sich ergebende Verringerung der Belegung des Innenvolumens (22) durch den ersten und den zweiten Körper (8, 10) zumindest teilweise auszugleichen, wobei die Nettozunahmerate des freien Volumens der Prozesskammer (6) während der Bewegung des ersten und des zweiten Körpers (8, 10) zumindest teilweise durch die Bewegung des dritten Körpers (14) begrenzt wird.

12. Verfahren, vorzugsweise gemäß Anspruch 11, zum Betreiben des Systems (2) gemäß einem der Ansprüche 4 bis 10, wobei, wenn sich der dritte Körper (14) in Richtung (n14) von der Innenposition in Richtung der Außenposition schneller als die jeweilige vorbestimmte Schwellenbewegungsgeschwindigkeit bewegt, zumindest einer der ersten und zweiten Körper (8, 10) dazu veranlasst wird, sich in Richtung (n8, n10) von der geöffneten Position in Richtung der geschlossenen Position zu bewegen, um die sich ergebende Verringerung der Belegung des Innenvolumens (22) durch den dritten Körper (14) zumindest teilweise auszugleichen, wobei die Nettozunahmerate des freien Volumens der Prozesskammer (6) während der Bewegung des dritten Körpers (14) zumindest teilweise durch die Bewegung des mindestens einen der ersten und zweiten Körper (8, 10) begrenzt wird.

13. Verfahren zur Behandlung eines einzelnen, aus Halbleitermaterial hergestellten Wafers (4) unter Verwendung des Systems (2) gemäß einem der Ansprüche 1 bis 10, wobei der Wafer (4) im Behandlungsbereich (12) behandelt wird, während sich der erste und der zweite Körper (8, 10) in der geschlossenen Position befinden, wobei das System (2) nach der Behandlung gemäß Anspruch 17 betrieben wird, um den Wafer (4) aus dem Behandlungsbereich (12) zu entfernen,
vorzugsweise, wobei das System (2) gemäß einem der Ansprüche 4 bis 10 ausgelegt ist und vor der Behandlung gemäß Anspruch 12 betrieben wird, um den Wafer (4) von außerhalb der Prozesskammer (6) in den Behandlungsbereich (12) aufzunehmen.

14. Steuerung (44), die für den Einsatz als Steuerung (44) des Systems (2) gemäß Anspruch 10 ausgelegt ist und so konfiguriert ist, dass sie während des Einsatzes als Teil des Systems (2) das Verfahren gemäß Anspruch 11 oder 12 automatisch ausführt.

15. Computerprogrammprodukt, das computerlesbare Befehle umfasst, die bei Ausführung durch einen Computer bewirken, dass der Computer als Steuerung (44) gemäß Anspruch 14 konfiguriert wird.

## Revendications

1. Système (2) de traitement d'une tranche individuelle (4) fabriquée à partir d'un matériau semi-conducteur, comprenant une chambre de traitement (6) délimitée par une paroi de chambre de traitement (7) définissant un volume intérieur (22) de la chambre de traitement (6), dans lequel la chambre de traitement (6) est pourvue d'un premier (8) et d'un deuxième (10) corps agencés pour s'étendre de manière mobile à travers la paroi de chambre de traitement (7) afin d'être mobiles l'un à l'opposé de l'autre d'une position fermée vers une position ouverte, et l'un vers l'autre de la position ouverte vers la position fermée, dans lequel, en position fermée, une tranche (4) positionnée dans une zone de traitement (12) entre les premier et deuxième corps (8, 10) peut être traitée via les premier et deuxième corps (8, 10), dans lequel, en position ouverte, la tranche (4) peut être déplacée dans et hors de la zone de traitement (12), dans lequel, en position ouverte, les premier et deuxième corps (8, 10) occupent une moindre partie du volume intérieur (22) de la chambre de traitement (6) par rapport à la position fermée,
dans lequel la chambre de traitement (6) est en outre pourvue d'un troisième corps (14) agencé pour s'étendre de manière mobile à travers la paroi de chambre de traitement (7) afin d'être mobile entre une position intérieure et une position extérieure, dans lequel, en position extérieure, le troisième corps (14) occupe une moindre partie du volume intérieur (22) de la chambre de traitement (6) par rapport à la position intérieure,
dans lequel un volume libre de la chambre de traitement (6) est défini comme la partie du volume intérieur (22) qui n'est occupée par aucun des premier, deuxième et troisième corps (8, 10, 14), dans lequel le système (2) est configuré pour limiter un taux net d'augmentation du volume libre de la chambre de traitement (6) lorsque les premier et deuxième corps (8, 10) se déplacent dans une direction (m8, m10) de la position fermée vers la position ouverte à une vitesse supérieure à un seuil prédéterminé de déplacement, dans lequel la limitation implique le déplacement du troisième corps (14) dans une direction (m14) de la position extérieure vers la position intérieure afin de compenser au moins partiellement une réduction de l'occupation du volume intérieur (22) par les premier et deuxième corps (8, 10) résultant de leur déplacement vers la position ouverte.

2. Système selon la revendication 1, dans lequel :
- pour compenser au moins partiellement la réduction de l'occupation du volume intérieur (22) par les premier et deuxième corps (8, 10), le système (2) est configuré pour déplacer le troisième corps (14) vers la position intérieure selon un profil de mouvement prédéterminé respectif lorsque les premier et deuxième corps (8, 10) se déplacent vers la position ouverte selon un profil de mouvement prédéterminé respectif ; et/ou
- le troisième corps (14) est configuré pour déplacer une tranche (4) dans la chambre de traitement (6) par déplacement du troisième corps (14) de la position intérieure vers la position extérieure, dans lequel, en position intérieure, une extrémité de réception de tranche (16) du troisième corps (14) est agencée au niveau d'une ouverture de chargement de tranche (18) ouvrable et refermable dans la paroi de chambre de traitement (7),
dans lequel le système comprend de préférence un sas (20) à l'extérieur de la chambre de traitement (6) pour charger une tranche (4) dans la chambre de traitement (6) via le sas (20), dans lequel l'ouverture de chargement de tranche (18), lorsqu'elle est ouverte, relie le volume intérieur (22) de la chambre de traitement (6) à un intérieur du sas (20).

3. Système selon l'une quelconque des revendications précédentes, dans lequel le troisième corps (14) est configuré pour refroidir une tranche (4) dans la chambre de traitement (6).

4. Système selon l'une quelconque des revendications précédentes, dans lequel le système (2) est configuré pour limiter un taux net d'augmentation du volume libre de la chambre de traitement (6) lorsque le troisième corps (14) se déplace dans une direction (n14) de la position intérieure vers la position extérieure à une vitesse supérieure à un seuil prédéterminé de déplacement, dans lequel la limitation implique le déplacement d'au moins l'un des premier et deuxième corps (8, 10) dans une direction (n8, n10) de la position ouverte vers la position fermée afin de compenser au moins partiellement une réduction de l'occupation du volume intérieur (22) par le troisième corps (14) résultant de son déplacement vers la position extérieure,
de préférence dans lequel, pour compenser au moins partiellement la réduction de l'occupation du volume intérieur (22) par le troisième corps (14), le système (2) est configuré pour déplacer au moins l'un des premier et deuxième corps (8, 10) vers la position fermée selon un profil de mouvement prédéterminé respectif lorsque le troisième corps (14) se déplace vers la position extérieure selon un profil de mouvement prédéterminé respectif.

5. Système selon l'une quelconque des revendications précédentes, configuré pour maintenir au moins sélectivement le volume libre de la chambre de traitement (6) à une surpression par rapport à un extérieur (24) de la chambre de traitement (6), au moins partiellement par déplacement d'un ou plusieurs des premier, deuxième et troisième corps (8, 10, 14),
de préférence dans lequel le système (2) est configuré pour limiter la surpression à un maximum de 40 mbar, de préférence à un maximum de 20 mbar, encore de préférence à un maximum de 10 mbar, encore de préférence à un maximum d'environ 5 mbar.

6. Système selon l'une quelconque des revendications précédentes, dans lequel les premier et deuxième corps (8, 10) en position fermée sont configurés pour chauffer une tranche (4) dans la zone de traitement (12) pour le recuit du matériau semi-conducteur.

7. Système selon l'une quelconque des revendications précédentes, dans lequel la chambre de traitement (6) est pourvue d'une entrée de gaz (26) pouvant être raccordée ou raccordée à une alimentation en gaz (28) et d'une sortie de gaz (30) pouvant être raccordée ou raccordée à un ensemble d'évacuation (32),
dans lequel le système comprend de préférence l'ensemble d'évacuation (32), l'ensemble d'évacuation (32) comprenant un canal d'évacuation (34) ayant une extrémité d'entrée de canal d'évacuation (36) pour le raccordement à la sortie de gaz (30) de la chambre de traitement (6) et une extrémité de sortie de canal d'évacuation (38) pour le raccordement à un ventilateur d'évacuation (40), dans lequel le canal d'évacuation (34) comprend une entrée intermédiaire (42) entre l'extrémité d'entrée de canal d'évacuation (36) et l'extrémité de sortie de canal d'évacuation (38), l'entrée intermédiaire (42) étant configurée pour permettre à l'air provenant d'un extérieur (24) de la chambre de traitement (6) d'être aspiré dans le canal d'évacuation (34) par le ventilateur d'évacuation (40) de manière à amortir la transmission en amont des fluctuations de pression depuis l'extrémité de sortie de canal d'évacuation (38) vers l'extrémité d'entrée de canal d'évacuation (36) via le canal d'évacuation (34).

8. Système selon l'une quelconque des revendications précédentes, configuré pour limiter au moins sélectivement une surpression du volume libre de la chambre de traitement (6) par rapport à un extérieur (24) de la chambre de traitement (6), au moins partiellement par déplacement d'un ou plusieurs des premier, deuxième et troisième corps (8, 10, 14).

9. Système selon l'une quelconque des revendications précédentes, dans lequel :
- le système (2) est configuré pour limiter un taux net de diminution du volume libre de la chambre de traitement (6) lorsque les premier et deuxième corps (8, 10) se déplacent dans une direction allant de la position ouverte vers la position fermée à une vitesse supérieure à un seuil prédéterminé de déplacement, dans lequel la limitation implique le déplacement du troisième corps (14) dans une direction allant de la position intérieure vers la position extérieure afin de compenser au moins partiellement une augmentation de l'occupation du volume intérieur (22) par les premier et deuxième corps (8, 10) résultant de leurs déplacements vers la position fermée ; et/ou
- le système (2) est configuré pour limiter un taux net de diminution du volume libre de la chambre de traitement (6) lorsque le troisième corps (14) se déplace dans une direction allant de la position extérieure vers la position intérieure à une vitesse supérieure à un seuil prédéterminé de déplacement, dans lequel la limitation implique le déplacement d'au moins l'un des premier et deuxième corps (8, 10) dans une direction allant de la position fermée vers la position ouverte afin de compenser au moins partiellement une augmentation de l'occupation du volume intérieur (22) par le troisième corps (14) résultant de son déplacement vers la position intérieure.

10. Système selon l'une quelconque des revendications précédentes, comprenant un contrôleur (44) relié ou pouvant être relié de manière fonctionnelle aux premier, deuxième et troisième corps (8, 10, 14), et configuré pour commander les mouvements des corps (8, 10, 14) lorsqu'il est connecté.

11. Procédé de fonctionnement du système (2) selon l'une quelconque des revendications précédentes, dans lequel, lorsque les premier et deuxième corps (8, 10) se déplacent dans la direction (m8, m10) de la position fermée vers la position ouverte à une vitesse supérieure au seuil prédéterminé de déplacement, le troisième corps (14) est amené à se déplacer dans la direction (n14) de la position extérieure vers la position intérieure afin de compenser au moins partiellement la réduction résultante de l'occupation du volume intérieur (22) par les premier et deuxième corps (8, 10), dans lequel le taux net d'augmentation du volume libre de la chambre de traitement (6) pendant le déplacement des premier et deuxième corps (8, 10) est limité au moins en partie par le déplacement du troisième corps (14).

12. Procédé, de préférence selon la revendication 11, de fonctionnement du système (2) selon l'une quelconque des revendications 4 à 10, dans lequel, lorsque le troisième corps (14) se déplace dans la direction (n14) de la position intérieure vers la position extérieure à une vitesse supérieure au seuil prédéterminé de déplacement respectif, au moins l'un des premier et deuxième corps (8, 10) est amené à se déplacer dans la direction (n8, n10) de la position ouverte vers la position fermée afin de compenser au moins partiellement la réduction résultante de l'occupation du volume intérieur (22) par le troisième corps (14), dans lequel le taux net d'augmentation du volume libre de la chambre de traitement (6) pendant le déplacement du troisième corps (14) est limité au moins en partie par le déplacement d'au moins l'un des premier et deuxième corps (8, 10).

13. Procédé de traitement d'une tranche individuelle (4) fabriquée à partir d'un matériau semi-conducteur à l'aide du système (2) selon l'une quelconque des revendications 1 à 10, dans lequel la tranche (4) est traitée dans la zone de traitement (12) tandis que les premier et deuxième corps (8, 10) sont en position fermée, dans lequel le système (2) est actionné selon la revendication 17 après le traitement pour retirer la tranche (4) de la zone de traitement (12),
de préférence dans lequel le système (2) est configuré selon l'une quelconque des revendications 4 à 10 et est actionné selon la revendication 12 avant le traitement pour recevoir la tranche (4) dans la zone de traitement (12) depuis l'extérieur de la chambre de traitement (6).

14. Contrôleur (44) configuré pour être utilisé comme contrôleur (44) du système (2) selon la revendication 10, configuré pour exécuter automatiquement le procédé selon la revendication 11 ou 12 lors de l'utilisation en tant que partie du système (2).

15. Produit de programme informatique comprenant des instructions lisibles par ordinateur qui, lorsqu'elles sont exécutées par un ordinateur, amènent l'ordinateur à être configuré comme un contrôleur (44) selon la revendication 14.
